# EUROPÄISCHE PATENTSCHRIFT

(11) **EP 0 224 866 B1**
(45) Veröffentlichungstag und Bekanntmachung des Hinweises auf die Patenterteilung: **17.02.1993**
(21) Anmeldenummer: 86116426.7
(22) Anmeldetag: 26.11.1986
(51) Int. Cl.: H03H 9/05, H03H 9/02

(54) **Oberflächenwellenbauelement**
Surface acoustic wave circuit element
Elément à ondes acoustiques de surface

(30) Priorität: 05.12.1985 DE 3543079; 26.02.1986 DE 3606214
(43) Veröffentlichungstag der Anmeldung: 10.06.1987
(73) Patentinhaber: SIEMENS AKTIENGESELLSCHAFT, 80333 München (DE)
(72) Erfinder: Zibis, Peter, D-8000 Munchen (DE); Pahl, Wolfgang, D-8000 Munchen 90 (DE)

(56) Entgegenhaltungen:
- US-A- 3 753 164
- PATENT ABSTRACTS OF JAPAN, Band 8, Nr. 115 (E-247)[1552], 29. Mai 1984; & JP-A-59 30 315 (FUJITSU K.K.) 17-02-1984
- PATENT ABSTRACTS OF JAPAN, Band 6, Nr. 12 (E-91)[890], 23. Januar 1982; & JP-A-56 134 819 (TOKYO SHIBAURA DENKI K.K.) 21-10-1981
- PATENT ABSTRACTS OF JAPAN, Band 4, Nr. 63 (E-10)[545], 13. Mai 1980, Seite 103 E 10; & JP-A-55 33 341 (TOKYO SHIBAURA DENKI K.K.) 08-03-1980
- REVIEW, Band 26. Nr. 11/12, November-Dezember 1978, Seiten 1675-1685, J. MINOWA et al.: "Narrow pass band surface acoustic wave filters for transmission system applications"
- PATENT ABSTRACTS OF JAPAN, Band 3, Nr. 90 (E-127), 31. Juli 1979, Seite 126 E 127; & JP-A-54 69 048 (NIPPON VICTOR K.K.) 06-02-1979
- PATENT ABSTRACTS OF JAPAN, Band 4, Nr. 59 (E-9)[541], 2. Mai 1980, Seite 125 E 9; & JP-A-55 30 221 (TOKYO SHIBAURA DENKI K.K.) 04-03-1980

## Beschreibung

Die vorliegende Erfindung bezieht sich auf ein ein gehaltertes Substratplättchen aufweisendes Oberflächenwellen-Bauelement, wie im Oberbegriff des Patentanspruches 1 näher angegeben.

Oberflächenwellen-Bauelemente sind hinlänglich bekannt. Vorzugsweise sind dies Filter bzw. Resonatoren und/oder Laufzeitleitungen. Wesentliche Merkmale solcher Bauelemente sind die auf der Oberfläche der Substratplatte angeordneten bzw. vorhandenen, die vorgegebenen Eigenschaften dieses Bauelementes im wesentlichen bestimmenden Wandler- und/oder Reflektorstrukturen. Diese Strukturen sind auf die Oberfläche aufgebrachte streifenförmige Fingerelektroden und/oder Reflektorstreifen sowie weitere Zusatzstrukturen, wie Pads, Abschirmelektroden und dgl.. Für Reflektorstrukturen sind anstelle metallischer Streifen auch (elektrisch nicht leitende) Ätzstrukturen der Substratoberfläche geläufig.

Ein solches Substratplättchen aus vorzugsweise Quarz, Lithiumniobat, Lithiumtantalat und dgl. ist regelmäßig auf einer Unterlage gehaltert und in einem Gehäuse angebracht, wobei zur Halterung zwischen der den Strukturen gegenüberliegenden, rückseitigen Oberfläche des Substratplättchens und der Unterlage ein Mittel mit Klebwirkung vorgesehen ist. Üblich ist über die rückseitige Oberfläche hinweg sich ganzflächig erstreckende Anordnung dieses Mittels, nämlich um eine satte Auflage des Substratplättchens auf der Unterlage zu haben.

Bevorzugt wird als Mittel mit Klebwirkung ein solches, das erhebliche Plastizität aufweist, so daß angenommenerweise z.B. aufgrund von Temperaturänderungen, auftretende Spannungen vom Substratplättchen weitgehend ferngehalten sind. Abdampfungen aus einem solchen viskosen Klebemittel, verbunden mit entsprechendem Niederschlag auf der die Strukturen tragenden Substratoberfläche des Substratplättchens, sind als Grund für aufgetretene Störungen angenommen worden, die sich aber nicht dadurch beseitigen ließen, daß man weniger Lösungsmittel bzw. Weichmacher enthaltende, dementsprechend härtere Kleber verwendet hat.

Eine andere Lösung des Problems, die Einwirkung einer thermischen Verformung der Unterlage zu verringern, ist in Patents Abstracts of Japan, Vol. 8, No. 115, E247, 1552 vom 29. Mai 19 84 beschrieben. Es ist dort das rechteckige Substratplättchen nur im Bereich seines einen schmalseitigen Endes auf die Unterlage aufgeklebt. Sein wesentlicher Rechteckanteil kragt von der Klebstelle ausgehend frei oberhalb der Unterlage. Eine solche Ausführung ist aber sehr empfindlich hinsichtlich auf das Filter einwirkender Erschütterungen.

Störungen zeigen sich in auffallendem Ausmaß besonders bei schmalbandigen Filtern und Resonatorbauelementen und/oder Laufzeitleitungen, wobei diese Störungen auf mechanischen Einwirkungen beruhen, die von Gehäuseteilen und von außen ausgehen bzw. einwirken.

Aus der US-A-3 753 164 und der US-A-4 450 420 sind Oberflächenwellenfilter mit trapezförmigen bzw. dreieckigen Substratplättchen bekannt. Die dort gewählte Formgebung dient der Verminderung von Reflexionen und/oder der Einsparung an Substratmaterial. In noch anderem Zusammenhang ist aus 1983 Ultrasonics Symposium, S. 268, Figur 4 die Verwendung eines Substratkörpers mit dreieckiger Form bekannt. Es handelt sich dabei um einen Kraftmesser mit einer auf der Oberfläche des Substratkörpers befindlichen Oberflächenwellenstruktur. Die Meßgröße liefert diese Struktur. Diese Oberflächenwellenstruktur, und zwar vor allem deren bestimmender Anteil, ist (siehe Fig. 4) dort wenigstens zu einem wesentlichen Anteil absichtlich nahe derjenigen Kante des dreiseitigen Substratkörpers plaziert, in deren Bereich dieser Substratkörper gehaltert ist. Die der Halterung gegenüberliegende Spitze ist weitgehend frei von einer solchen Struktur.

Aus der europäischen Patentanmeldung, Publikations-Nr. EP-A-0 156 502, ist eine Oberflächenwellenanordnung mit rhombusförmiger Gestalt bekannt. Dieser Rhombus wird im mittleren Bereich gehaltert, nämlich dort, wo sich der Hauptteil bzw. der bestimmende Anteil der Oberflächenwellenstruktur befindet.

Unter "bestimmendem Anteil" sind die vorgegebenen Eigenschaften der Oberflächenwellenstruktur wesentlich (mit-)bestimmenden Anteile der Wandler- und/oder Reflektorstruktur gemeint. Die Mittellage einer solchen Struktur gibt dabei einen gewissen Grenzbereich an, von dem ab, gesehen vom Zentrum der Struktur hin zu diesem gehalterten Ende, die bestimmenden Eigenschaften dieser Struktur stark abnehmend sind.

Aufgabe der vorliegenden Erfindung ist es, Maßnahmen für ein Oberflächenwellen-Bauelement anzugeben, mit denen bei bekannten Bauelementen dieser Art aufgetretene Störungen zu minimieren sind.

Diese Aufgabe wird mit den Merkmalen des Patentanspruches 1 gelöst und weitere Ausgestaltungen und Weiterbildungen der Erfindung gehen aus den Unteransprüchen hervor.

Das auch bei der Erfindung verwendete spitz- oder stumpfkeilförmige Substratplättchen ist wiederum an seinem breiten ersten Ende durch z.B. Klebstoff gehaltert, der sich hier nicht weiter als bis höchstens zur Mittellage der von diesem Ende her gesehen ersten bestimmenden Struktur erstreckt. Die wesentlichen Anteile der gesamten Oberflächenwellenstruktur dieses Bauelementes erstrecken sich erfindungsgemäß dagegen über den Bereich des gegenüberliegenden Endes des keilförmigen Substratplättchens, obwohl im Bereich dieses Endes des "Keiles" das Substratplättchen an sich außerordentlich empfindlich hinsichtlich Biegungen desselben ist. Überraschenderweise wirken sich bei dem Oberflächenwellen-Bauelement mit dieser verwendeten Gestalt und mit Plazierung der Wandlerstrukturen im Bereich des der Halterung entgegengesetzten Endes, die aufgrund der nur einseitigen Halterung zu erwartende Biegungen des Substratplättchens bei der Erfindung gerade besonders wenig störend auf das Verhalten bzw. auf die Eigenschaften dieses Bauelements aus. Mit der erfindungsgemäßen Bauform kann man Oberflächenwellen-Bauelemente herstellen, die nur ein Minimum an solchen Störungen aufweisen, die auf der Montage des Substratplättchens nach bekannter Praxis beruhen.

Eine bevorzugte Form des Substratplättchens eines verwendeten Oberflächenwellen-Bauelementes ist die eines Keiles mit einer Oberfläche gleich einem wenigstens nahezu gleichseitigen Dreieck, d.h. mit spitzen Winkeln von 60°. Die eine Seite dieses Dreiecks ist das erwähnte erste Ende. Von diesem gehalterten, ersten Ende des Substratplättchens erstreckt dieses sich freitragend bis zu seinem gegenüberliegenden zweiten Ende, das die eine Dreiecksspitze ist. Entlang dieser Längserstreckung ist die Oberflächenwellen-Struktur angeordnet, und zwar bis weit in diese Spitze hineinreichend, d.h. im wesentlichen in dem Bereich, der der Halterung möglichst weit entfernt ist.

Weitere Erläuterungen der Erfindung gehen aus der nachfolgenden Beschreibung zu Ausführungsbeispielen der Erfindung hervor.

Figur 1 zeigt eine bevorzugte Ausführungsform eines Bauelementes nach der Erfindung.

Figur 2 gibt Hinweise auf eine weitere Form des Substratplättchens.

Figur 3 zeigt schematisch Maßnahmen zur Herstellung einer Vielzahl von Exemplaren einer Ausführungsform nach Figur 1.

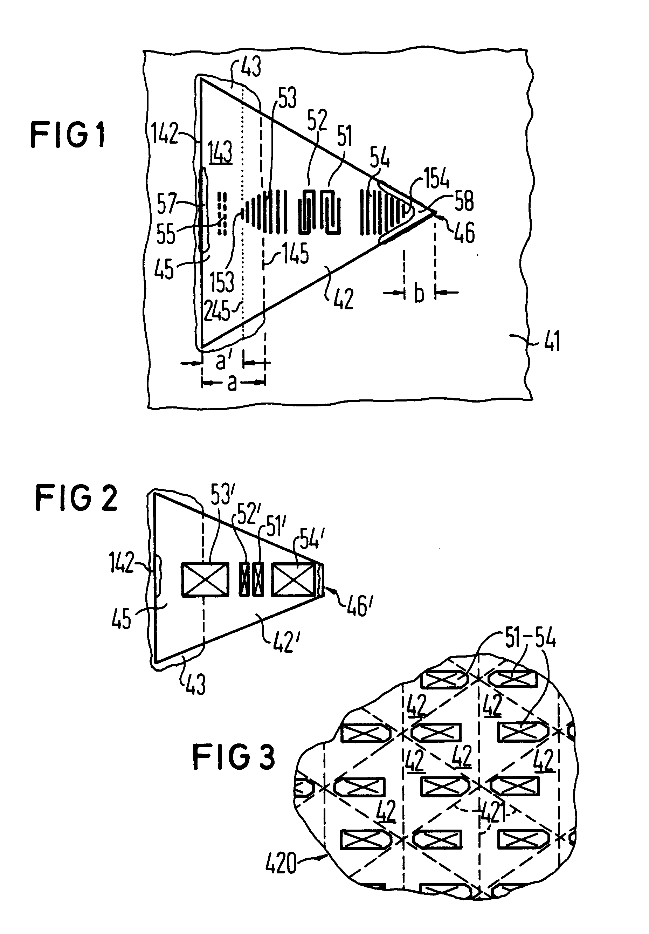

Mit 42 ist in Figur 1 ein Substratplättchen in Aufsicht dargestellt. Die Dicke des Substratplättchens ist wie üblich bemessen und ist insbesondere überall gleich groß. Das Substratplättchen 42 besteht z.B. aus Lithiumniobat oder -tantalat. Die Oberflächenform des Substratplättchens 42 ist beispielsweise ein gleichseitiges Dreieck.

Mit 52 und 51 sind zwei Interdigitalstrukturen bezeichnet, die z.B. als Eingangswandler und als Ausgangswandler des Bauelementes zu verwenden sind. Mit 53 und 54 sind zugehörige Reflektorstrukturen bezeichnet. Diese Strukturen 51 bis 54 sind in-line angeordnet. Wie aus der Figur ersichtlich reicht diese Anordnung der Strukturen 51 bis 54 weit in die in der Figur rechtsseitige Spitze bzw. weit in dieses Ende 46 des Substratplättchens 42 hinein. Insbesondere ist die Reflektorstruktur 54, wie dargestellt, sogar so ausgeführt, daß die Streifen bzw. Finger zum letzten Finger 154 hin entsprechend der Verringerung der Breite des Substratplättchens kürzer werden. Vorzugsweise wird eine entsprechende Verkürzung der Finger der Reflektorstruktur 53 vorgesehen, so daß auch der letzte Finger 153 der Reflektorstruktur 53 relativ kurz ist.

Das Substratplättchen 42 befindet sich auf einer Unterlage 41, von der nur Umrisse in Form abgebrochener Kanten dargestellt sind. Diese Unterlage 41 befindet sich zusammen mit dem Substratplättchen 42 in einem nicht dargestellten Gehäuse.

Wie bereits in der vorangegangenen Beschreibung hervorgehoben, ist das Substratplättchen 42 auf der Unterlage 41 nur an dem einen (ersten) Ende 45 auf der Unterlage 41 gehaltert. Dieses erste Ende 45 ist der Nachbarbereich der einen Dreieckskante 142 des Substratplättchens 42. Für diese (einseitige) Halterung des Substratplättchens 42 an seinem ersten Ende 45 auf der Unterlage 41 sind Mittel mit Verbindungswirkung, insbesondere Klebstoff, vorgesehen. Mit 43 ist zwischen der (in der Figur) Unterseite des Substratplättchens 42 und der (in der Figur sichtbaren) Oberseite der Unterlage 41 befindlicher Kleber bezeichnet. Die zwischen dem Substratplättchen 42 und der Unterlage 41 befindliche Schichtdicke dieses Klebers 43 ist so groß bemessen, daß das ganze Substratplättchen 42 außerhalb des Bereichs 143 dieses Mittels 43 mit ausreichendem Abstand über der Unterlage 41 frei "schwebt" bzw. frei herausragt. Wichtig ist die Lage der Grenze 145 des Mittels 43, und zwar deren Lage in bezug auf die Reflektorstruktur 53. Wie dies auch schon in der älteren obengenannten Anmeldung angegeben ist, kann diese Grenze 145 (auf der Unterseite des Substratplättchens 42) bis in den Bereich bzw. bis zu der definierten Mittellage der Reflektorstruktur 53 reichen.

Die Strukturen 51 bis 54 und insbesondere die Reflektorstrukturen 53 und 54 sind die vorgegebenen Eigenschaften des Bauelementes wesentlich bestimmende Strukturen. Sie bestimmen z.B. die Resonanzfrequenz, Bandbreite und dgl. eines Filters. Die Verhältnisse sind jedoch regelmäßig derart, daß die (vom Zentrum der Strukturen 51 bis 54 gesehen) weiter außen liegenden Anteile der Reflektorstruktur 53 (und der Reflektorstruktur 54) weniger stark bzw. (nach außen hin zunehmend) für die bestimmenden Eigenschaften weniger maßgeblich sind. So ist z.B. der in der Figur 1 links von dieser Grenze 145 liegende Anteil der Reflektorstruktur 53 (mit dem letzten Finger 153) nur noch in untergeordnetem Maße mitbestimmend für die (vorgegebenen) Eigenschaften des ganzen Filters. Aus dem entsprechenden Grunde konnte z.B. auch die Reflektorstruktur 54 zum zweiten Ende 46 des Substratplättchens 42 hin mit abnehmender Fingerlänge ausgebildet werden.

Bei der Erfindung sind die die vorgegebenen Eigenschaften des Bauelementes wesentlich bestimmenden Strukturen auf dem Substratplättchen derart plaziert, daß eine unsymmetrische Anordnung bzw. Verteilung der Strukturen auf der Substratoberfläche vorliegt.

Zum Beispiel wird als Mittel 43 ein solches Klebmittel verwendet, das als harter Kleber zu bezeichnen ist. Besonders geeignet sind vorvernetzte Epoxydharze und Polyimide. Günstig ist es, einen solchen Kleber zu verwenden, der wenig fließend ist. Für die Erfindung sind aber als Mittel mit Verbindungswirkung auch andere Mittel anwendbar, wie z.B. Glaslot, Bonden, Legieren und dgl.. Hierfür werden vor dem Verbinden Schichten, vorzugsweise aus Metall, auf dem Substratplättchen 42 und/oder der Unterlage 41 in dem für das Mittel 43 bzw. für die Halterung des ersten Endes 45 des Substratplättchens 42 vorgesehenen Bereich 143 aufgebracht. Die Verbindung kann dann durch diese Schicht (-en) bewirkt sein. Auch eine solche Verbindung ist für die vorliegende Erfindung zweckmäßigerweise hart. Mit den erfindungsgemäßen Maßnahmen, wie sie beispielsweise bei der Ausführungsform nach Figur 1 realisiert sind, wird nicht nur erreicht, daß vom Gehäuse ausgehende, insbesondere temperaturänderungsbedingte Verbiegungen der Unterlage 41 sich nicht auf die vorgegebenen Eigenschaften des Bauelementes auswirken können, sondern daß auch Erschütterungen des Bauelementes trotz der einseitigen Halterung keinen störenden Einfluß ausüben, und zwar dies trotz der Tatsache, daß sich die Strukturen 51 bis 54 auf dem Substratplättchen in einem Bereich desselben befinden, der Biegungen ausführen kann.

Mit 57 und 58 sind angebrachte Dämpfungsmassen üblicher Art bezeichnet.

Lediglich schematisch ist mit 55 eine Fingerstruktur angedeutet, die sich in dem Bereich 143 des Mittels 43 mit Verbindungswirkung befindet. Es handelt sich bei der Struktur 55 jedoch um eine solche, die nicht-mitbestimmend ist für die Eigenschaften des Bauelementes. Eine solche Struktur 55 kann z.B. ein weiterer Ausgangswandler für ein Steuersignal sein, der auf die eigentlichen bestimmenden Strukturen 51 bis 54 keine Rückwirkung hat.

Es ist nicht ausgeschlossen, daß das Substratplättchen 42 auf der Oberfläche der Unterlage 41 leicht aufliegen kann. Vorzugsweise ist aber ein kleiner Abstand bzw. Luftspalt zwischen dem Substratplättchen 42 und der Unterlage 41 vorgesehen. Insbesondere darf die Dämpfungsmasse 58 keine solche Verbindung mit der Unterlage 41 bewirken, die der Erfnidung entgegenwirkt.

Wie aus der Figur ersichtlich, ist die Länge a,aʹ zwischen der Kante 142 und dem letzten Finger 153 der Struktur 53 deutlich größer als die Länge b zwischen dem letzten Finger 154 der Struktur 54 und der Spitze 46 des Substratplättchens 42. Dies ermöglicht eine solide Halterung des Substratplättchens 42 mittels z.B. des Klebers 43 auf der Unterlage 41.

Es ist oben darauf hingewiesen worden, daß der Rand 145 bis maximal zur Mittellage der Struktur 53 reichen kann, nämlich wie dies in der Figur mit der gestrichelten Linie angedeutet ist. Die punktierte Linie 245 weist auf eine Lage dieses Randes des Mittels 43 hin, die ebenfalls erfindungsgemäß ist. Welche genaue Lage dieses Randes zwischen 145 und 245 gewählt wird, ist für die Erfindung von geringer Bedeutung. Eine Verkürzung der Länge a zu aʹ verringert die Breite des Bereichs 143 der Halterung. Die Erstreckung der Länge a bis zur Grenze 145 bietet in diesem Sinne Vorteile, ohne nennenswerte Einbuße bezüglich der erfindungsgemäß erreichten Störunempfindlichkeit hinnehmen zu müssen.

Abmessungen eines erfindungsgemäß verwendeten Substratplättchens 42 sind z.B.: Die Länge zwischen der Kante 142 und dem Ende 46 beträgt z.B. 6 mm und die Länge a z.B. 0,5 bis 1 mm. Der Luftspalt liegt im Bereich von µm bis zu einigen Zehnteln Millimetern.

Figur 2 zeigt als weiteres Beispiel ein Substratplättchen 42ʹ in der Form eines am zweiten Ende 46ʹ abgestumpften bzw. abgeschnittenen Keiles mit der Kante 142ʹ seines ersten Endes 45ʹ.

Figur 3 zeigt einen Ausschnitt einer Substratplatte 420 mit einer Anzahl Substratplättchen 42, auf denen sich die Strukturen (diese nur andeutungsweise dargestellt) befinden. Die kreuzweise verlaufenden, gestrichelten Linien deuten die Schnittlinien an, in denen die Substratplatte in die einzelnen Substratplättchen 42 bzw. die Bauelemente nach Figur 1 zerschnitten wird.

## Patentansprüche

1. Oberflächenwellen-Bauelement, das ein gehaltertes Substratplättchen aufweist, vorzugsweise eines schmalbandigen, frequenzgenauen Filters bzw. Resonators oder einer Laufzeitleitung, wobei sich dieses Substratplättchen auf einer Unterlage befindet und für die Halterung ein Mittel mit Verbindungswirkung zwischen dem Substratplättchen und der Unterlage nur im Bereich (143) eines ersten Endes (45) des Substratplättchens (42) verwendet ist, wobei ein zweites Ende (46) des Substratplättchens freischwebend ist, und wobei die, die vorgegebenen Eigenschaften des Bauelementes wesentlich bestimmenden Wandler- und/oder Reflektorstrukturen und dgl. auf der Substratoberfläche angeordnet sind,
**gekennzeichnet dadurch,**
daß sich das Mittel (43) mit der Verbindungswirkung nur maximal bis etwa zur Mittellage (145) der dem ersten Ende auf der Substratoberfläche nächstliegenden bestimmenden Struktur (53) erstreckt, und
daß das Substratplättchen (42), bezogen auf seine Oberfläche, eine sich verjüngende Form hat, so daß das erste Ende (45) des Substratplättchens breit ist und das gegenüberliegende zweite Ende (46) eine dagegen schmalere bis spitze Form hat,
wobei mechanische Verspannungen des Materials des Substratplättchens (42), die auf das Substratplättchen im Bereich der auf der Oberfläche befindlichen, die vorgegebenen Eigenschaften des Bauelements wesentlich bestimmenden Strukturen einwirken könnten, minimiert sind.

2. Oberflächenwellen-Bauelement nach Anspruch 1, **gekennzeichnet dadurch,** daß das Substratplättchen (42) eine Oberfläche eines gleichseitigen Dreiecks hat (Fig. 1, Fig. 3).

3. Oberflächenwellen-Bauelement nach Anspruch 1, **gekennzeichnet dadurch,** daß das Substratplättchen (42') die Form eines stumpfen Keiles hat (Fig. 2).

4. Oberflächenwellen-Bauelement nach Anspruch 1, 2 oder 3, **gekennzeichnet dadurch,** daß die Grenze (245) des Halterungsbereiches (145) nur bis an das äußere Ende (153) der dem Halterungsbereich (143) nächst benachbarten, bestimmenden Struktur (53) reicht.

5. Oberflächenwellen-Bauelement nach einem der Ansprüche 1 bis 4, **gekennzeichnet dadurch,** daß die Strukturen (51 bis 54) bis an das verjüngte Ende (46) des Substratplättchens (42) reicht.

6. Oberflächenwellen-Bauelement nach einem der Ansprüche 1 bis 5, **gekennzeichnet dadurch,** daß zwischen den sich gegenüberliegenden Oberflächen des Substratplättchens (42) und der Unterlage (41) ein nur geringer Luftspalt eingehalten ist.

7. Oberflächenwellen-Bauelement nach einem der Ansprüche 1 bis 6, **gekennzeichnet dadurch,** daß das Mittel (43) mit Verbindungswirkung ein Klebstoff ist.

8. Oberflächenwellen-Bauelement nach einem der Ansprüche 1 bis 6, **gekennzeichnet dadurch,** daß das Mittel (43) mit Verbindungswirkung ein Glaslot ist.

9. Oberflächenwellen-Bauelement nach einem der Ansprüche 1 bis 6, **gekennzeichnet dadurch,** daß das Mittel (43) mit Verbindungswirkung eine metallische Bondschicht ist.

10. Oberflächenwellen-Bauelement nach einem der Ansprüche 1 bis 6, **gekennzeichnet dadurch,** daß das Mittel (43) mit Verbindungswirkung legierbare Metallschichten sind.

11. Verfahren zur Herstellung eines Oberflächenwellen-Bauelementes nach einem der Ansprüche 1 bis 10, **gekennzeichnet dadurch,** daß zunächst auf einer, vergleichsweise zu dem Substratplättchen (42), großen Substratscheibe (420) den Bauelementen mit den Substratplättchen (42) entsprechende Strukturen (51 bis 54) aufgebracht werden und dann die Substratscheibe (420) den einzelnen Substratplättchen (42) entsprechend entlang solcher Geraden (421) zerschnitten wird, die einzelne Geraden entweder einer ersten Schar paralleler Geraden, oder einer zweiten Schar paralleler Geraden oder einer dritten Schar paralleler Geraden sind, wobei sich die Geraden aller drei Scharen in Punkten der zu zerschneidenden Oberfläche kreuzen.

## Claims

1. Surface-wave component which has a substrate platelet that is held, preferably a narrowband, precise-frequency filter or resonator or a delay line, this substrate platelet being located on a base and a means being used for holding which has a connecting effect between the substrate platelet and the base only in the region (143) of a first end (45) of the substrate platelet (42), a second end (46) of the substrate platelet being cantilevered, and the converter and/or reflector structures and the like which essentially determine the specified properties of the component being arranged on the substrate surface,
characterised in that the means (43) having the connecting effect extends at most only approximately as far as the central point (145) of the determining structure (53) located closest to the first end of the substrate surface, and
in that the substrate platelet (42) has a tapering shape with respect to its surface, so that the first end (45) of the substrate platelet is broad and the opposite second end (46) in contrast has a narrower shape to a shape with a tip,
mechanical stresses in the material of the substrate platelet (42), which could act on the substrate platelet in the region of the structures which are located on the surface and essentially determine the specified properties of the component being minimised.

2. Surface-wave component according to Claim 1, characterised in that the substrate platelet (42) has a surface of an equilateral triangle (Fig. 1, Fig. 3).

3. Surface-wave component according to Claim 1, characterised in that the substrate platelet (42') has the shape of a truncated wedge (Fig. 2).

4. Surface-wave component according to Claim 1, 2, or 3, characterised in that the boundary (245) of the holding region (145) extends only as far as the outer end (153) of the determining structure (53) which is most adjacent to the holding region (143).

5. Surface-wave component according to one of Claims 1 to 4, characterised in that the structures (51 to 54) extend to the tapered end (46) of the substrate platelet (42).

6. Surface-wave component according to one of Claims 1 to 5, characterised in that only a small air gap is maintained between the mutually opposite surfaces of the substrate platelet (42) and the base (41).

7. Surface-wave component according to one of Claims 1 to 6, characterised in that the means (43) having the connecting effect is an adhesive material.

8. Surface-wave component according to one of Claims 1 to 6, characterised in that the means (43) having the connecting effect is a glass solder.

9. Surface-wave component according to one of Claims 1 to 6, characterised in that the means (43) having the connecting effect is a metallic bonding layer.

10. Surface-wave component according to one of Claims 1 to 6, characterised in that the means (43) having the connecting effect are metal layers which can be alloyed.

11. Method for producing a surface-wave component according to one of Claims 1 to 10, characterised in that structures (51 to 54) which correspond to the components having the substrate platelets (42) are initially deposited onto a substrate wafer (420) which is large in comparison with the substrate platelet (42), and the substrate wafer (420) is then cut, along straight lines (421), corresponding to the individual substrate platelets (42), which individual straight lines are either of a first family of parallel straight lines or a second family of parallel straight lines or a third family of parallel straight lines, the straight lines of all three families intersecting at points on the surface which is to be cut.

## Revendications

1. Composant à ondes de surface, qui possède une plaquette formant substrat supportée, de préférence d'un filtre ou d'un résonateur à bande étroite et possédant une fréquence précise ou d'une ligne à retard, et dans lequel cette plaquette formant substrat est disposée sur un support et que pour son maintien, il est prévu un moyen établissant une liaison entre la plaquette formant substrat et le support uniquement dans la zone (143) d'une première extrémité (45) de la plaquette formant substrat (42), et dans lequel une seconde extrémité (46) de la plaquette formant substrat est disposée en porte-à-faux, et dans lequel les structures de transducteurs et/ou de réflecteurs et analogues, qui déterminent essentiellement les caractéristiques prédéterminées du composant, sont disposées sur la surface du substrat,
caractérisé par le fait
que le moyen (43) réalisant une liaison s'étend seulement au maximum approximativement jusque dans la position médiane (145) de la structure de détermination (53) qui est la plus proche de la première extrémité sur la surface du substrat, et
que la plaquette formant substrat (42) possède une forme rétrécie en ce qui concerne sa surface de sorte que la première extrémité (45) de la plaquette formant substrat est large et que la seconde extrémité opposée (46) possède une forme qui au contraire est plus étroite ou même pointue,
des déformations mécaniques du matériau de la plaquette formant substrat (42), qui peuvent agir sur la plaquette formant substrat dans la zone située sur la surface et qui déterminent pour l'essentiel les caractéristiques prédéterminées du composant, étant réduites.

2. Composant à ondes de surface suivant la revendication 1, caractérisé par le fait que la plaquette formant substrat (42) possède la surface d'un triangle équilatéral (figure 1, figure 3).

3. Composant à ondes de surface suivant la revendication 1, caractérisé par le fait que la plaquette formant substrat (42') possède la forme d'un coin tronqué (figure 2).

4. Composant à ondes de surface suivant la revendication 1, 2 ou 3, caractérisé par le fait que la limite (245) de la zone de fixation (145) s'étend uniquement jusqu'à l'extrémité extérieure (153) de la structure de détermination (53), qui est plus voisine de la zone de fixation (143).

5. Composant à ondes de surface suivant l'une des revendications 1 à 4, caractérisé par le fait que les structures (51 à 54) s'étendent jusqu'à l'extrémité rétrécie (46) de la plaquette formant substrat (42).

6. Composant à ondes de surface suivant l'une des revendications 1 à 5, caractérisé par le fait qu'une fente seulement étroite est maintenue entre les surfaces, situées en vis-à-vis, de la plaquette formant substrat (42) et du support (41).

7. Composant à ondes de surface suivant l'une des revendications 1 à 6, caractérisé par le fait que le moyen (43) établissant une liaison est un adhésif.

8. Composant à ondes de surface suivant l'une des revendications 1 à 6, caractérisé par le fait que le moyen (43) établissant une liaison est de la soudure de verre.

9. Composant à ondes de surface suivant l'une des revendications 1 à 6, caractérisé par le fait que le moyen (43) établissant une liaison est une couche de liaison métallique.

10. Composant à ondes de surface suivant l'une des revendications 1 à 6, caractérisé par le fait que le moyen (43) ayant une action de liaison est formé par des couches métalliques pouvant être alliées.

11. Composant à ondes de surface suivant l'une des revendications 1 à 10, caractérisé par le fait qu'on dépose tout d'abord des structures (51 à 54), qui correspondent aux composants équipés des plaquettes de substrat (42), sur un disque formant substrat (420), qui est étendu comparativement à la plaquette de substrat (42), et qu'on subdivise ensuite le disque formant substrat (420) conformément aux différentes plaquettes de substrat (42), le long de droites (421), qui sont des droites individuelles qui soit font partie d'un premier ensemble de droites parallèles, soit d'un second ensemble de droites parallèles, soit d'un troisième ensemble de droites parallèles, les droites des trois ensembles de droites se recoupant en des points de la surface devant être subdivisée.
